# EUROPEAN PATENT SPECIFICATION

(11) **EP 3 330 721 B1**
(45) Date of publication and mention of the grant of the patent: **03.06.2020**
(21) Application number: 16202012.7
(22) Date of filing: 02.12.2016
(51) Int. Cl.: G01R 15/14, G01R 15/26

(54) **SENSING DEVICE FOR SWITCHGEAR AND TRANSMISSION LINE**
ERFASSUNGSVORRICHTUNG FÜR SCHALTGERÄT UND ÜBERTRAGUNGSLEITUNG
DISPOSITIF DE DÉTECTION POUR DISPOSITIF DE COMMUTATION ET LIGNE DE TRANSMISSION

(43) Date of publication of application: 06.06.2018
(73) Proprietor: General Electric Technology GmbH, 5400 Baden (CH)
(72) Inventor: VUACHET, Jacques, 74330 Poisy (FR); JUGE, Patrice, 74150 Marcellas Albanais (FR); GRANELLI, Guillaume, 38530 Chapareillan (FR)
(74) Representative: Freigutpartners IP Law Firm

(56) References cited:
- EP-A1- 2 731 214
- GB-A- 2 321 713
- US-A- 4 724 381

## Description

### TECHNICAL FIELD

The invention concerns a sensing device comprising an insulating support configured to mechanically support a high voltage member of a high voltage transmission line, the insulating support comprising a high voltage insert, a low voltage insert and an insulating member, the high voltage insert and the low voltage insert being made in a conductive material, the insulating member being arranged between the high voltage insert and the low voltage insert to provide electrical insulation between the high voltage insert and the low voltage insert.

The invention also concerns a transmission line.

The invention applies to electrical distribution, and more particularly to gas insulated substations.

### BACKGROUND ART

It is known to use transmission lines to convey currents having high magnitudes, for instance up to 1000 A.

Such transmission lines are generally designed according to the standards of gas technology: such transmission lines comprise a central conductor arranged within a grounding tube, at a distance from the grounding tube, an insulating gas filling the volume between the conductor and the grounding tube. Insulating supports are usually arranged within the grounding pipe to support the conductor, while providing electrical insulation between the conductor and the grounding tube.

The currents that flow through the conductors of such transmission lines having high magnitudes, heat is generally generated. This heat causes the temperature of the insulating support to rise. Therefore, the temperature of the insulating support may exceed a glass transition temperature T_{g} of the material in which the insulating support is made. This phenomenon may lead to a degradation of the insulating support and of its physical properties, leading to safety issues.

Therefore, such transmission lines usually comprise sensing devices, such sensing devices including, for instance, a temperature sensor to monitor the temperature of the conductor. GB2321713 A describes an alarm and control system to control high power electrical networks and measures parameters of AC high voltage transmission lines by means of a remote terminal unit that comprises an opto-coupler. EP 2731214 A1 describes a temperature monitoring device and method for a high voltage conductor. US 4724381 A describes a RF antenna for a transmission line sensor.

However, such sensing devices are usually not able to provide a direct measurement of the temperature of the conductor, making such sensing devices unreliable. Moreover, such sensing devices require specific modifications of the transmission line to be inserted in the transmission line, which raises the costs associated with electrical distribution.

The purpose of the invention is to provide a sensing device that is more reliable. Such sensing device is also cost effective, since it takes advantage of the already existing insulating supports with their inserts which are located at typically interesting measuring points of the transmission line.

### SUMMARY OF THE INVENTION

To this end, the present invention is a sensing device of the aforementioned type, wherein the sensing device further comprises a transponder and at least one sensor, the transponder being connected to the high voltage insert, and each sensor being connected to the transponder,
each sensor being configured to transmit, to the transponder, sensing information relative to a predetermined monitored property of the transmission line,
the transponder being configured to transmit to the high voltage insert a sensing signal comprising the sensing information,
the high voltage insert being configured to radiate a sensing electromagnetic wave depending on the sensing signal,
the low voltage insert being configured to receive the radiated sensing electromagnetic wave and to provide an output signal representative of the sensing signal at an output of the low voltage insert.

Indeed, in such a sensing device, the high voltage insert is intended to be located near the conductor. This allows the sensors to accurately measure the monitored property, for instance the temperature of the conductor.

Moreover, the measurements being sent wirelessly from the high voltage insert to the low voltage insert, no modification of the transmission line is required, which reduces manufacturing costs.

According to other advantageous aspects of the invention, the sensing device includes one or more of the following characteristics, taken alone or in any possible combination:
- the low voltage insert is further configured to receive an energizing signal and to radiate an energizing electromagnetic wave depending on the energizing signal, the high voltage insert being configured to receive the radiated energizing electromagnetic wave and to provide an input signal representative of the energizing signal to the transponder, the transponder being configured to convey part of the input signal to each sensor to energize each sensor;
- the high voltage insert comprises a socket, the transponder being arranged in the socket;
- the transponder is configured to modulate a primary signal comprising the sensing information received from each sensor at a predetermined operating frequency, the operating frequency being included in a frequency band ranging from 125 KHz to 5850 MHz, for instance a frequency band ranging from 800 Hz to 1000 MHz;

- at least one sensor is a temperature sensor or a pressure sensor arranged in the socket;
- the low voltage insert is configured to receive a discharge electromagnetic wave generated by partial discharges, and to provide, as an output, a discharge signal depending on the discharge electromagnetic wave.

The invention also relates to a transmission line comprising a sensing device as described above, and further comprising a grounding pipe and a high voltage member arranged within the grounding pipe and spaced apart from the grounding pipe, the insulating support being arranged within the grounding pipe to mechanically support the high voltage member, the low voltage insert being in contact with the grounding pipe through an outer insulating element, and the high voltage insert being in contact with the high voltage member through an inner insulating element.

According to other advantageous aspects of the invention, the transmission line includes one or more of the following characteristics, taken alone or in any possible combination:
- the inner insulating element comprises an inductor having one terminal connected to the high voltage member and another terminal connected to the high voltage insert;
- the high voltage member comprises a disconnect switch having a fixed electrode and a conductor, the insulating support mechanically supporting the electrode, the conductor being operable to move between an engaged position, where a distal end of the conductor is in electrical contact with a contacting region of the electrode, and a disengaged position, where the electrode and the conductor are not in electrical contact with each other, a magnet being arranged at the distal end of the conductor, a switch being arranged at the contacting region of the electrode, the switch being connected to the transponder to form a sensor of the sensing device, the magnet being configured to bring the switch in a first state when the conductor is in the engaged position, and to bring the switch in a second state when the conductor is in the disengaged position;
- the conductor is further operable to move into a retracted position, where the conductor is spaced away from the electrode, the distal end of the conductor being disengaged from the contacting region of the electrode, the conductor and the electrode not being in electrical contact with each other, the conductor being retracted in a sleeve, the distal end of the conductor being located at an entrance of the sleeve, a confirmation switch being arranged at the entrance of the sleeve, the magnet being configured to bring the confirmation switch in a first state when the conductor is in the retracted position, and to bring the confirmation switch in a second state when the conductor is not in the disengaged position.

### BRIEF DESCRIPTION OF THE DRAWINGS

The invention will be better understood with the attached figures, in which:
- figure 1 is a cross-section detail of a first embodiment of a transmission line according to the invention, in a plane comprising a conductor and an insulating support of the transmission line;
- figure 2 is a detailed view of the insulating support of figure 1;
- figure 3 is a detailed view of a high voltage insert of the insulating support of figure 2;
- figure 4 is a schematic view of a sensing device according to the invention;
- figure 5 is a cross-section detail of a second embodiment of the transmission line according to the invention, in a plane comprising a longitudinal axis of the conductor; and
- figure 6 is a detail of a schematic view of a first embodiment of a disconnect switch according to the invention, the disconnect switch being in a closed state;
- figure 7 is a detail of a schematic view of the disconnect switch of figure 6, the disconnect switch being in an open state;
- figure 8 is a detail of a schematic view of a second embodiment of a disconnect switch according to the invention, a conductor of the disconnect switch being in an engaged position; and
- figure 9 is a detail of a schematic view of the disconnect switch of figure 6, the conductor being in a retracted position.

### DESCRIPTION OF PREFERED EMBODIMENTS

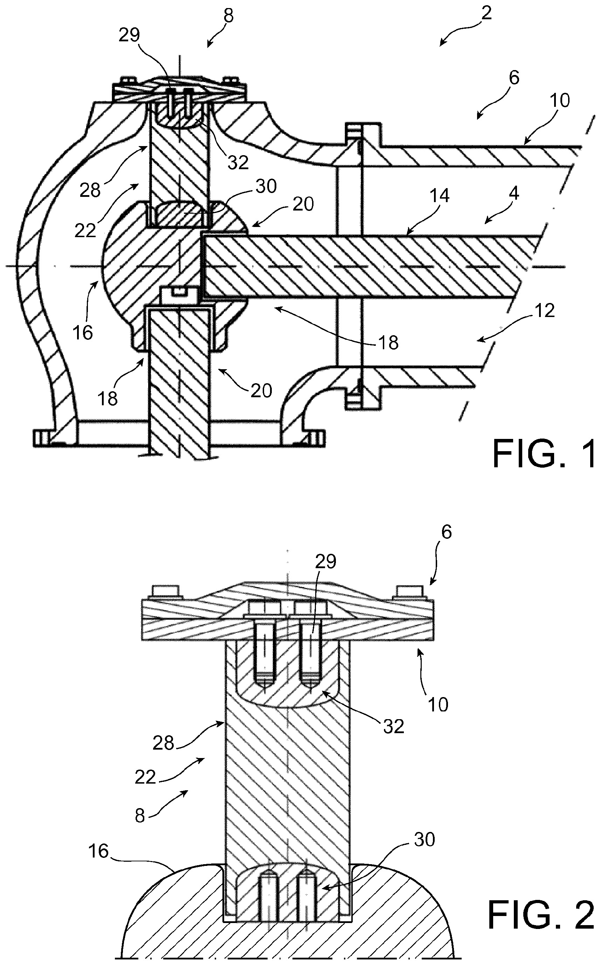

A part of a transmission line 2 according to the invention is shown on figure 1. The transmission line 2 is designed according to the standards of SF₆ technology (SF₆ standing for "sulfur hexafluoride"). For instance, the transmission line 2 is a part of a gas insulated switchgear.

The transmission line 2 comprises a high voltage member 4, a grounding pipe 6 enclosing the high voltage member 4, and a sensing device 8.

The high voltage member 4 is able to convey electric current from a first end of the transmission line 2 to a second end of the transmission line 2.

The grounding pipe 6 is configured to be electrically connected to a reference electric potential source, for instance to be connected to the ground. The grounding pipe 6 is also configured to allow the circulation of a reverse current flowing in an opposite direction relative to the current flowing in the high voltage member 4.

The sensing device 8 is configured to provide information relative to at least one predetermined monitored property of the transmission line 2. For instance, the predetermined monitored properties include the temperature of the high voltage member 4, the pressure of an insulating gas within the pipe 6, or the state of a disconnect switch, as will be described later. The sensing device 8 is further configured to detect the occurrence of partial discharges within the transmission line 2.

The sensing device 8 is also configured to mechanically support the high voltage member 4.

The grounding pipe 6 forms an outer part of the transmission line 2.

The grounding pipe 6 comprises a wall 10. The wall 10 is made of an electrically conductive material, such as a metal. The wall 10 defines a cavity 12 inside the grounding pipe 6. The cavity 12 is filled with an insulating gas. For instance, such an insulating gas is sulfur hexafluoride (also known as SF₆).

The high voltage member 4 forms an inner part of the transmission line 2. The high voltage member 4 is arranged in the cavity 12 of the grounding pipe 6, the high voltage member 4 being spaced apart from the grounding pipe 6.

For instance, as shown on figure 1, the high voltage member 4 comprises a plurality of conductors 14 arranged in series. In this case, an electrode 16 is provided between two successive conductors 14 to connect the successive conductors 14.

The conductors 14 and the electrode 16 are made of an electrically conductive material, such as a metal.

As shown on figure 1, the conductors 14 are preferably solid cylinders. Moreover, the electrode 16 has the general shape of a sphere.

The electrode 16 comprises a plurality of recesses 18. Each recess 18 is associated with a conductor 14 and forms a contacting region between the electrode 16 and the corresponding conductor 14. More specifically, a distal end 20 of each conductor 14 is engaged in a corresponding recess 18 to electrically connect each conductor 14 to the electrode 16.

Turning to figures 1 to 4, the sensing device 8 comprises an insulating support 22, a transponder 24 and at least one sensor 26. Optionally, the sensing device 8 further includes a computer 27.

Each sensor 26 is connected to the transponder 24. Moreover, the transponder 24 is connected to a high voltage insert 30 of the insulating support 22, described below.

The insulating support 22 is arranged within the grounding pipe 6.

The insulating support 22 is configured to mechanically support the high voltage member 4. In the example shown on figures 1 to 3, the insulating support 22 supports the electrode 16.

Preferably, the insulating support 22 is fastened to the grounding pipe 6 and to the electrode 16, for instance using electrically insulated screws 29, as shown on figures 1-3.

The insulating support 22 comprises an insulating member 28, a high voltage insert 30 and a low voltage insert 32.

The insulating member 28 is a solid cylinder made of an insulating material, such as epoxy.

Each of the high voltage insert 30 and the low voltage insert 32 is made in a conductive material. For instance, each of the high voltage insert 30 and the low voltage insert 32 has a hemispherical shape.

Each of the high voltage insert 30 and the low voltage insert 32 is inserted at a respective end of the insulating member 28, the insulating member 28 being arranged between the high voltage insert 30 and the low voltage insert 32 to provide electrical insulation between the high voltage insert 30 and the low voltage insert 32.

The high voltage insert 30 is in mechanical contact with the electrode 16 through an inner insulating element 34. The low voltage insert 32 is in mechanical contact with the wall 10 of the grounding pipe 6 through an outer insulating element 36. For instance, each of the inner insulating element 34 and the outer insulating element 36 is a ceramic disc able to provide insulation between the high voltage insert 30 and the high voltage member 4, and between the low voltage insert 32 and the grounding pipe 6, respectively.

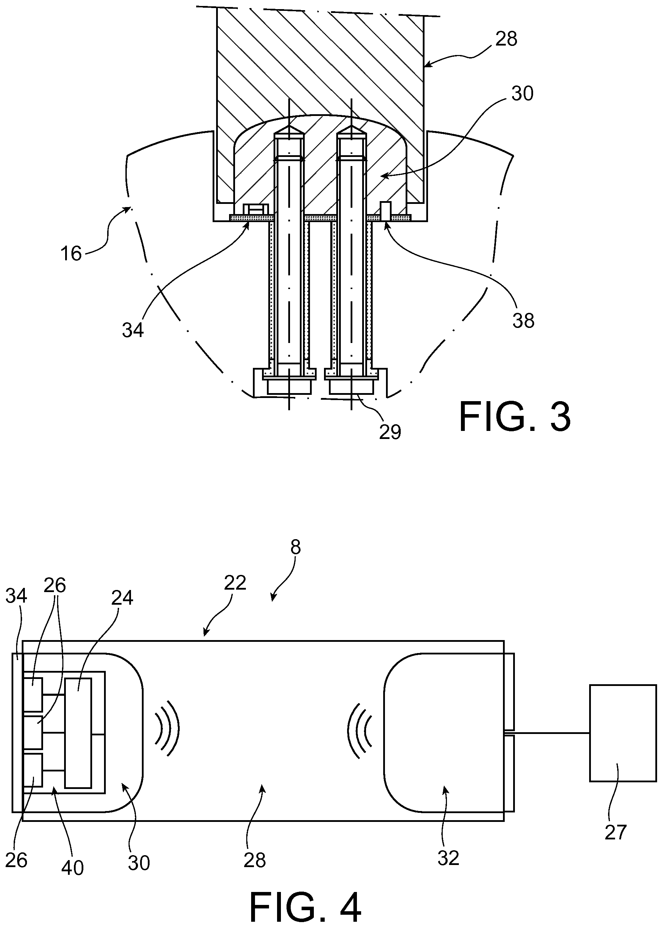

Preferably, the inner insulating element 34 comprises an inductor 38 having one terminal connected to the electrode 16 and another terminal connected to the high voltage insert 30, as shown on figure 3.

Furthermore, the high voltage insert 30 comprises a socket 40, for instance adjacent to the inner insulating element 34.

The high voltage insert 30 is configured to radiate a sensing electromagnetic wave depending on a sensing signal received from the transponder 24, as described below. In this case, the low voltage insert 32 is configured to receive the radiated sensing electromagnetic wave and to provide an output signal representative of the sensing signal at an output of the low voltage insert 32.

The low voltage insert 32 is further configured to receive an energizing signal and to radiate an energizing electromagnetic wave depending on the energizing signal. In this case, the high voltage insert 30 is also configured to receive the radiated energizing electromagnetic wave and to provide an input signal representative of the energizing signal to the transponder 24.

Advantageously, the low voltage insert 32 is also configured to receive a discharge electromagnetic wave generated by partial discharges within the transmission line 2. In this case, the low voltage insert 32 is configured to provide, as an output, a discharge signal depending on the discharge electromagnetic wave.

Advantageously, the transponder 24 is arranged in the socket 40.

The transponder 24 is configured to receive, from each sensor 26, a primary signal comprising sensing information relative to a predetermined monitored property of the transmission line 2 associated with the sensor 26.

The transponder 24 is further configured to generate the sensing signal, the sensing signal being a signal comprising the sensing information received from each sensor 26. For instance, the transponder 24 is configured to modulate the primary signal, received from each sensor 26, at a predetermined operating frequency to generate the sensing signal. The operating frequency depends on the frequency of the energizing signal. Preferably, the operating frequency belongs to a frequency band ranging from 125 KHz to 5850 MHz, for instance a frequency band ranging from 800 Hz to 1000 MHz.

The transponder 24 is also configured to transmit the sensing signal to the high voltage insert 30.

Furthermore, the transponder 24 is configured to receive the input signal from the high voltage insert 30. In this case, the transponder 24 is further configured to convey part of the input signal to each sensor 26 to energize each sensor 26. The transponder 24 is also configured to operate using part of the input signal provided by the high voltage insert 30.

Each sensor 26 is, for instance, a temperature sensor, a pressure sensor or a position switch, such as a reed switch. If the sensor 26 is a temperature sensor or a pressure sensor, the sensor 26 is preferably arranged in the socket 40.

In the case where the sensor 26 is a temperature sensor, the sensor 26 is, for instance, a resistance thermometer such as a PT100 probe.

The computer 27 is electrically connected to the low voltage insert 32.

The computer 27 is configured to receive the output signal available at the low voltage insert 32. The computer 27 is further configured to process the output signal to extract the sensing information collected by the sensors 26. Preferably, the computer 27 is also configured to extract the discharge signal available at the output of the low voltage insert 32, and to process the extracted discharge signal to detect the occurrence of partial discharges within the transmission line 2.

Advantageously, the computer 27 is further configured to apply the energizing signal to the low voltage insert 32.

The operation of the sensing device 8 will now be described with reference to figure 4.

The computer 27 applies the energizing signal to the low voltage insert 32, and the low voltage insert 32 radiates an energizing electromagnetic wave depending on the energizing signal.

Then, the high voltage insert 30 receives the radiated energizing electromagnetic wave and provides to the transponder 24 an input signal that is representative of the energizing signal.

Then, the transponder 24 uses part of the input signal provided by the high voltage insert 30 to operate. The transponder 24 further conveys part of the input signal to each sensor 26 to energize each sensor 26.

Each sensor 26 sends to the transponder 24 a primary signal comprising sensing information relative to the predetermined monitored property associated with the sensor 26.

The transponder 24 receives the primary signal from the sensors 26 and processes the primary signal to generate the sensing signal.

Then, the transponder 24 transmits the sensing signal to the high voltage insert 30, and the high voltage insert 30 radiates the sensing electromagnetic wave.

Then, the low voltage 32 receives the radiated sensing electromagnetic wave and provides the output signal, which is representative of the sensing signal, at the output of the low voltage insert 32. The computer 27 receives output signal and further processes the output signal to extract the sensing information collected by the sensors 26.

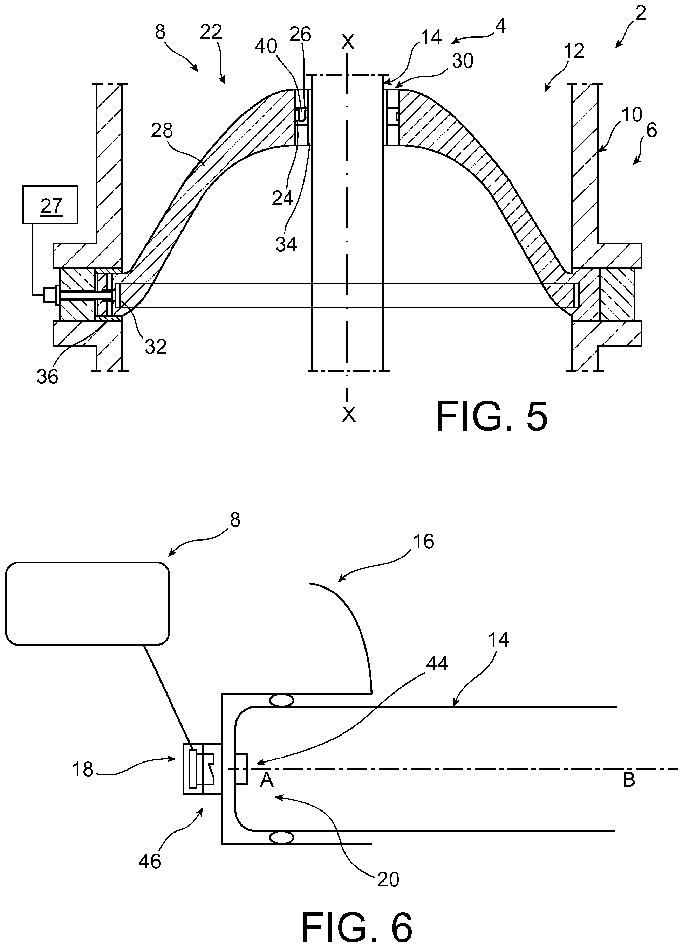

In another embodiment, shown on figure 5, the supporting member 22 directly supports the conductor 14. As can be seen on the figure, the grounding pipe 6 has a rotational symmetry around a longitudinal axis X-X. The conductor 14 extends along the longitudinal axis X-X.

In this case, the supporting member 22 also has a rotational symmetry around the longitudinal axis X-X. For instance, as shown on figure 5, the supporting member 22 is cone-shaped. The conductor 14 extends through the vertex of the cone-shaped supporting member 22. Moreover, the base of the cone-shaped supporting member 22 is in mechanical contact with the grounding pipe 6.

More precisely, the supporting member 22 comprises a cone-shaped insulating member 28, and ring-shaped high voltage insert 30 and a ring shaped low voltage insert 32.

The high voltage insert 30 is located at the vertex of the cone-shaped insulating member 28. The high voltage insert 30 has a rotational symmetry around the longitudinal axis X-X. The conductor 14 extends through the center of the ring-shaped high voltage insert 30. The inner insulating element 34 is also ring shaped and concentric with the high voltage insert 30. The inner insulating element 34 is arranged between the conductor 14 and the high voltage insert 30.

Furthermore, the low voltage insert 32 is located at the base of the cone-shaped insulating member 28. The low voltage insert 32 has a rotational symmetry around the longitudinal axis X-X. The conductor 14 extends through the center of the ring-shaped low voltage insert 32. The outer insulating element 36 is also ring shaped and arranged between the grounding pipe 6 and the low voltage insert 32.

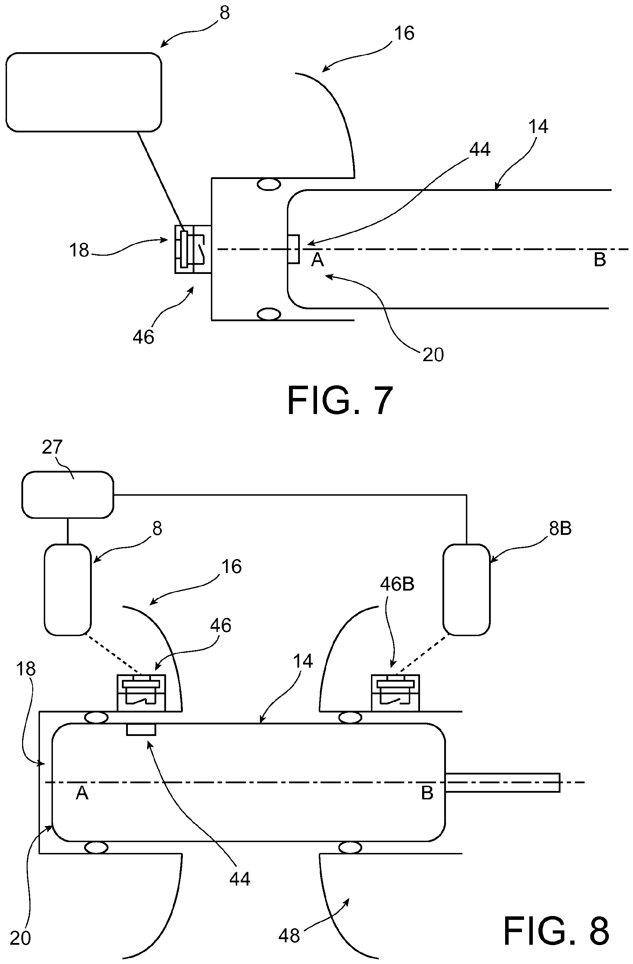

In another embodiment, shown on figures 6 and 7, the high voltage member 4 comprises a disconnect switch 42. The disconnect switch 42 is configured to mechanically interrupt the circulation of electric current in the high voltage member 4 of the transmission line 2. The disconnect switch 42 is arranged within the grounding tube 6. The disconnect switch 42 includes an electrode 16 and a conductor 14.

The electrode 16 is fixed with respect to the grounding tube 6. The electrode 16 is supported by the insulating support 22 of a sensing device 8 according to the invention.

The conductor 14 is operable to move along a displacement path A-B between an engaged position and a disengaged position.

In the engaged position, the distal end 20 of the conductor 14 is engaged in the corresponding recess 18 of the electrode 16, the conductor 14 being in electrical contact with the electrode 16. The engaged position corresponds to a closed state of the disconnect switch 42, where the electric current is allowed to flow in the high voltage member 4.

In the disengaged position, the distal end 20 of the conductor 14 is disengaged from the corresponding recess 18 of the electrode 16, the conductor 14 and the electrode 16 not being in electrical contact with each other. The disengaged position corresponds to an open state of the disconnect switch 42, where the electric current cannot flow in the high voltage member 4.

A magnet 44 is arranged at the distal end 20 of the conductor 14. Moreover, a position switch, such as a reed switch 46, is arranged in the recess 18. The reed switch 46 is also connected to the transponder 24 of the sensing device 8 to form a sensor 26 able to detect the state of the disconnect switch 42.

The operation of the disconnect switch 42 will now be described with reference to figures 6 and 7.

When the disconnect switch 42 is in the closed state, shown on figure 6, the distal end 20 of the conductor 14 is engaged in the corresponding recess 18 of the electrode 16. The magnet 44 faces the reed switch 46 and causes the reed switch 46 to be in a closed state. Therefore, the sensing device 8 detects that the disconnect switch 42 is in the closed state.

When the disconnect switch 42 is controlled to switch from the closed state to the open state, the distal end 20 of the conductor 14 disengages from the corresponding recess 18 of the electrode 16 as the conductor 14 moves away from the electrode 16 along the displacement path A-B until the conductor 14 reaches the disengaged position, as shown on figure 7.

In the disengaged position, the magnet 44 does not face the reed switch 46, which causes the reed switch 46 to switch to an open state. Therefore, the sensing device 8 detects that the disconnect switch 42 has switched to the open state.

It appears that the reed switch 46 forms a sensor of the state of the disconnect switch 42.

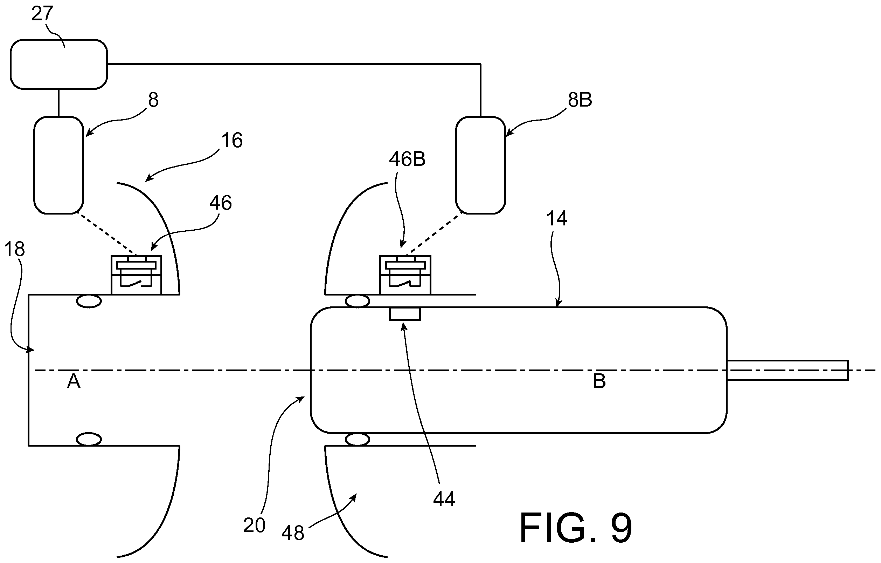

In another embodiment, shown on figures 8 and 9, the conductor 14 is further operable to move along the displacement path A-B past the disengaged position, into a fully retracted position.

In the retracted position, the distal end 20 of the conductor 14 is disengaged from the corresponding recess 18 of the electrode 16, the conductor 14 and the electrode 16 not being in electrical contact with each other. Furthermore, in the retracted position, the conductor 14 is retracted in a sleeve 48, away from the electrode 16. In the retracted position, the distal end 20 of the conductor 14 is located at an entrance 50 of the sleeve 48.

For instance, the distance between the recess 18 and the entrance 50 of the sleeve 48 ranges from 10 cm to 30 cm.

As shown on figure 8, a confirmation sensing device 8B is provided at the sleeve 48. The confirmation sensing device 8B is similar to the sensing device 8. Preferably, the confirmation sensing device 8B is connected to the computer 27 of the sensing device 8 associated with the electrode 16.

A confirmation reed switch 46B is arranged at the entrance 50 of the sleeve 48. The confirmation reed switch 46B is connected to a transponder 24B of the confirmation sensing device 8B to form a sensor able to detect the state of the disconnect switch 42.

Concerning the engaged position and the disengaged position, the operation of the disconnect switch 42 of figures 8 and 9 is similar to the operation of the disconnect switch 42 of figures 6 and 7. Particularly, in the engaged position and the disengaged position, the confirmation reed switch 46B is in an open state.

The operation of the disconnect switch 42 of figures 8 and 9 concerning the retracted position will now be described with reference to figure 9.

When the disconnect switch 42 is controlled to bring the conductor 14 into the retracted position, the conductor 14 moves further away from the electrode 16 along the displacement path A-B and retracts into the sleeve 48.

When the distal end 20 of the conductor 14 reaches the entrance 50 of the sleeve 48, as shown on figure 9, the magnet 44 faces the confirmation reed switch 46B and causes the confirmation reed switch 46B to be in a closed state. Therefore, the computer 27 receives an output signal originating from the confirmation sensing device 8B and detects that the conductor 14 is in the retracted position.

The ability of the low voltage insert 32 to radiate the energizing electromagnetic wave allows to wirelessly energize the transponder 24 and the sensors 26. This prevents from modifying the transmission line 2, which reduces manufacturing costs, since the implementation of the function is based on already existing insulating supports with their inserts.

The socket 40 allows to protect the transponder 24 from high electrical field, since the socket 40 behaves as a potential pit.

The modulation of the primary signal allows to easily distinguish the sensing electromagnetic wave from the electromagnetic wave generated by partial discharges in the transmission line 2.

The ability to receive the discharge electromagnetic wave and to output a discharge signal depending on the discharge electromagnetic wave allows to detect the occurrence of partial discharges in the transmission line 2.

## Claims

1. A sensing device (8) for a high voltage transmission line (2),
comprising a high voltage insert (30), a low voltage insert (32) and an insulating member (28), the high voltage insert (30) and the low voltage insert (32) being made in a conductive material, the insulating member (28) being arranged between the high voltage insert (30) and the low voltage insert (32) to provide electrical insulation between the high voltage insert (30) and the low voltage insert (32),
the sensing device (8) further comprises a transponder (24) and at least one sensor (26), the transponder (24) being connected to the high voltage insert (30), and each sensor (26) being connected to the transponder (24),
each sensor (26) being configured to transmit, to the transponder (24), sensing information relative to a predetermined monitored property of the transmission line (2),
the transponder (24) being configured to transmit to the high voltage insert (30) a sensing signal comprising the sensing information,
the high voltage insert (30) being configured to radiate a sensing electromagnetic wave depending on the sensing signal,
the low voltage insert (32) being configured to receive the radiated sensing electromagnetic wave and to provide an output signal representative of the sensing signal at an output of the low voltage insert (32), **characterized in that** the sensing device (8) comprises an insulating support (22) configured to mechanically support a high voltage member (4) of the high voltage transmission line (2), whereas the high voltage insert (30), the low voltage insert (32) and the insulating member (28) are comprised by the insulating support (22).

2. The sensing device (8) according to claim 1, wherein the low voltage insert (32) is further configured to receive an energizing signal and to radiate an energizing electromagnetic wave depending on the energizing signal,
the high voltage insert (30) being configured to receive the radiated energizing electromagnetic wave and to provide an input signal representative of the energizing signal to the transponder (24),
the transponder (24) being configured to convey part of the input signal to each sensor (26) to energize each sensor (26).

3. The sensing device (8) according to claim 1 or 2, wherein the high voltage insert (30) comprises a socket (40), the transponder (24) being arranged in the socket (40).

4. The sensing device (8) according to any one of claims 1 to 3, wherein the transponder (24) is configured to modulate a primary signal comprising the sensing information received from each sensor (26) at a predetermined operating frequency, the operating frequency being included in a frequency band ranging from 125 KHz to 5850 MHz, for instance a frequency band ranging from 800 Hz to 1000 MHz.

5. The sensing device (8) according to any one of claims 1 to 4, wherein at least one sensor (26) is a temperature sensor (26) or a pressure sensor (26) arranged in the socket (40).

6. The sensing device (8) according to any one of claims 1 to 5, wherein the low voltage insert (32) is configured to receive a discharge electromagnetic wave generated by partial discharges, and to provide, as an output, a discharge signal depending on the discharge electromagnetic wave.

7. A transmission line (2) comprising a sensing device (8) according to any one of claims 1 to 6, the transmission line (2) further comprising a grounding pipe (6) and a high voltage member (4) arranged within the grounding pipe (6) and spaced apart from the grounding pipe (6), the insulating support (22) being arranged within the grounding pipe (6) to mechanically support the high voltage member (4), the low voltage insert (32) being in contact with the grounding pipe (6) through an outer insulating element (36), and the high voltage insert (30) being in contact with the high voltage member (4) through an inner insulating element (34).

8. The transmission line (2) according to claim 7, wherein the inner insulating element (34) comprises an inductor (38) having one terminal connected to the high voltage member (4) and another terminal connected to the high voltage insert (30).

9. The transmission line (2) according to claim 7 or 8, wherein the high voltage member (4) comprises a disconnect switch (42) having a fixed electrode (16) and a conductor (14), the insulating support (22) mechanically supporting the electrode (16), the conductor (14) being operable to move between an engaged position, where a distal end (20) of the conductor (14) is in electrical contact with a contacting region of the electrode (16), and a disengaged position, where the electrode (16) and the conductor (14) are not in electrical contact with each other, a magnet (44) being arranged at the distal end (20) of the conductor (14), a switch (46) being arranged at the contacting region of the electrode (16), the switch (46) being connected to the transponder (24) to form a sensor (26) of the sensing device (8), the magnet (44) being configured to bring the switch (46) in a first state when the conductor (14) is in the engaged position, and to bring the switch (46) in a second state when the conductor (14) is in the disengaged position.

10. The transmission line (2) according to claim 9, wherein the conductor (14) is further operable to move into a retracted position, where the conductor (14) is spaced away from the electrode (16), the distal end (20) of the conductor (14) being disengaged from the contacting region of the electrode (16), the conductor (14) and the electrode (16) not being in electrical contact with each other, the conductor (14) being retracted in a sleeve (48), the distal end (20) of the conductor (14) being located at an entrance (50) of the sleeve (48), a confirmation switch (46B) being arranged at the entrance (50) of the sleeve (48), the magnet (44) being configured to bring the confirmation switch (46B) in a first state when the conductor (14) is in the retracted position, and to bring the confirmation switch (46B) in a second state when the conductor (14) is not in the disengaged position.

## Patentansprüche

1. Erfassungsvorrichtung (8) für eine Hochspannungsübertragungsleitung (2),
umfassend einen Hochspannungseinsatz (30), einen Niederspannungseinsatz (32) und ein Isolierglied (28), wobei der Hochspannungseinsatz (30) und der Niederspannungseinsatz (32) aus einem leitenden Material hergestellt sind, wobei das Isolierglied (28) zwischen dem Hochspannungseinsatz (30) und dem Niederspannungseinsatz (32) angeordnet ist, um eine elektrische Isolierung zwischen dem Hochspannungseinsatz (30) und dem Niederspannungseinsatz (32) bereitzustellen,
wobei die Erfassungsvorrichtung (8) weiter einen Transponder (24) und mindestens einen Sensor (26) umfasst, wobei der Transponder (24) mit dem Hochspannungseinsatz (30) verbunden ist und jeder Sensor (26) mit dem Transponder (24) verbunden ist,
wobei jeder Sensor (26) konfiguriert ist, um an den Transponder (24) Erfassungsinformationen in Bezug auf eine vorbestimmte überwachte Eigenschaft der Übertragungsleitung (2) zu übertragen,
wobei der Transponder (24) konfiguriert ist, um an den Hochspannungseinsatz (30) ein Erfassungssignal zu übertragen, das die Erfassungsinformationen umfasst,
wobei der Hochspannungseinsatz (30) konfiguriert ist, um eine elektromagnetische Erfassungswelle in Abhängigkeit vom Erfassungssignal abzustrahlen,
wobei der Niederspannungseinsatz (32) konfiguriert ist, um die abgestrahlte elektromagnetische Erfassungswelle zu empfangen und ein Ausgangssignal bereitzustellen, das für das Erfassungssignal an einem Ausgang des Niederspannungseinsatzes (32) repräsentativ ist, **dadurch gekennzeichnet, dass** die Erfassungsvorrichtung (8) einen isolierenden Träger (22) umfasst, der konfiguriert ist, um ein Hochspannungsglied (4) der Hochspannungsübertragungsleitung (2) mechanisch zu tragen, während der Hochspannungseinsatz (30), der Niederspannungseinsatz (32) und das Isolierglied (28) von dem isolierenden Träger (22) umfasst werden.

2. Erfassungsvorrichtung (8) nach Anspruch 1, wobei der Niederspannungseinsatz (32) weiter konfiguriert ist, um ein Erregungssignal zu empfangen und eine erregende elektromagnetische Welle in Abhängigkeit von dem Erregungssignal abzustrahlen,
wobei der Hochspannungseinsatz (30) konfiguriert ist, um die abgestrahlte erregende elektromagnetische Welle zu empfangen und dem Transponder (24) ein Eingangssignal bereitzustellen, das für das Erregungssignal repräsentativ ist,
wobei der Transponder (24) konfiguriert ist, einen Teil des Eingangssignals an jeden Sensor (26) zu übermitteln, um jeden Sensor (26) zu erregen.

3. Erfassungsvorrichtung (8) nach Anspruch 1 oder 2, wobei der Hochspannungseinsatz (30) eine Fassung (40) umfasst, wobei der Transponder (24) in der Fassung (40) angeordnet ist.

4. Erfassungsvorrichtung (8) nach einem der Ansprüche 1 bis 3, wobei der Transponder (24) konfiguriert ist, um ein Primärsignal zu modulieren, das die von jedem Sensor (26) empfangenen Erfassungsinformationen bei einer vorbestimmten Betriebsfrequenz umfasst, wobei die Betriebsfrequenz in einem Frequenzband im Bereich von 125 KHz bis 5850 MHz eingeschlossen ist, zum Beispiel einem Frequenzband im Bereich von 800 Hz bis 1000 MHz.

5. Erfassungsvorrichtung (8) nach einem der Ansprüche 1 bis 4, wobei mindestens ein Sensor (26) ein Temperatursensor (26) oder ein Drucksensor (26) ist, der in der Fassung (40) angeordnet ist.

6. Erfassungsvorrichtung (8) nach einem der Ansprüche 1 bis 5, wobei der Niederspannungseinsatz (32) konfiguriert ist, um eine durch Teilentladungen erzeugte elektromagnetische Entladungswelle zu empfangen und als Ausgang ein von der elektromagnetischen Entladungswelle abhängiges Entladungssignal bereitzustellen.

7. Übertragungsleitung (2), die eine Erfassungsvorrichtung (8) nach einem der Ansprüche 1 bis 6 umfasst, wobei die Übertragungsleitung (2) weiter eine Erdungsleitung (6) und ein Hochspannungsglied (4) umfasst, das innerhalb der Erdungsleitung (6) angeordnet und von der Erdungsleitung (6) beabstandet ist, wobei der isolierende Träger (22) innerhalb der Erdungsleitung (6) angeordnet ist, um das Hochspannungsglied (4) mechanisch zu tragen, wobei der Niederspannungseinsatz (32) über ein äußeres Isolierglied (36) mit der Erdungsleitung (6) in Kontakt steht und der Hochspannungseinsatz (30) über ein inneres Isolierglied (34) mit dem Hochspannungsglied (4) in Kontakt steht.

8. Übertragungsleitung (2) nach Anspruch 7, wobei das innere Isolierglied (34) einen Induktor (38) umfasst, dessen ein Anschluss mit dem Hochspannungsglied (4) und ein anderer Anschluss mit dem Hochspannungseinsatz (30) verbunden ist.

9. Übertragungsleitung (2) nach Anspruch 7 oder 8, wobei das Hochspannungsglied (4) einen Trennschalter (42) mit einer festen Elektrode (16) und einem Leiter (14) aufweist, wobei der isolierende Träger (22) die Elektrode (16) mechanisch trägt, wobei der Leiter (14) zwischen einer Eingriffsposition, in der ein distales Ende (20) des Leiters (14) in elektrischem Kontakt mit einem Kontaktbereich der Elektrode (16) ist, und einer Außereingriffsposition, in der die Elektrode (16) und der Leiter (14) nicht in elektrischem Kontakt miteinander sind, bewegbar ist, wobei ein Magnet (44) am distalen Ende (20) des Leiters (14) angeordnet ist, wobei ein Schalter (46) im Kontaktbereich der Elektrode (16) angeordnet ist, wobei der Schalter (46) mit dem Transponder (24) verbunden ist, um einen Sensor (26) der Erfassungsvorrichtung (8) zu bilden, wobei der Magnet (44) konfiguriert ist, um den Schalter (46) in einen ersten Zustand zu bringen, wenn der Leiter (14) in der Eingriffsposition ist, und um den Schalter (46) in einen zweiten Zustand zu bringen, wenn der Leiter (14) in der Außereingriffsposition ist.

10. Übertragungsleitung (2) nach Anspruch 9, wobei der Leiter (14) weiter betreibbar ist, um sich in eine zurückgezogene Position zu bewegen, in welcher der Leiter (14) von der Elektrode (16) beabstandet ist, wobei das distale Ende (20) des Leiters (14) von dem Kontaktbereich der Elektrode (16) gelöst ist, wobei der Leiter (14) und die Elektrode (16) nicht in elektrischem Kontakt miteinander stehen, wobei der Leiter (14) in eine Hülse (48) zurückgezogen ist, wobei sich das distale Ende (20) des Leiters (14) an einem Eingang (50) der Hülse (48) befindet, wobei ein Bestätigungsschalter (46B) am Eingang (50) der Hülse (48) angeordnet ist, wobei der Magnet (44) konfiguriert ist, um den Bestätigungsschalter (46B) in einen ersten Zustand zu bringen, wenn sich der Leiter (14) in der zurückgezogenen Position befindet, und um den Bestätigungsschalter (46B) in einen zweiten Zustand zu bringen, wenn sich der Leiter (14) nicht in der gelösten Position befindet.

## Revendications

1. Dispositif de détection (8) pour une ligne de transmission à haute tension (2),
comprenant un insert haute tension (30), un insert basse tension (32) et un élément isolant (28), l'insert haute tension (30) et l'insert basse tension (32) étant faits d'un matériau conducteur, l'élément isolant (28) étant agencé entre l'insert haute tension (30) et l'insert basse tension (32) pour fournir une isolation électrique entre l'insert haute tension (30) et l'insert basse tension (32),
le dispositif de détection (8) comprend en outre un transpondeur (24) et au moins un capteur (26), le transpondeur (24) étant connecté à l'insert haute tension (30), et chaque capteur (26) étant connecté au transpondeur (24),
chaque capteur (26) étant configuré pour transmettre, au transpondeur (24), des informations de détection relatives à une propriété surveillée prédéterminée de la ligne de transmission (2),
le transpondeur (24) étant configuré pour transmettre à l'insert haute tension (30) un signal de détection comprenant les informations de détection,
l'insert haute tension (30) étant configuré pour émettre une onde électromagnétique de détection en fonction du signal de détection,
l'insert basse tension (32) étant configuré pour recevoir l'onde électromagnétique de détection émise et pour fournir un signal de sortie représentatif du signal de détection à une sortie de l'insert basse tension (32), **caractérisé en ce que** le dispositif de détection (8) comprend un support isolant (22) configuré pour supporter mécaniquement un élément haute tension (4) de la ligne de transmission à haute tension (2), tandis que l'insert haute tension (30), l'insert basse tension (32) et l'élément isolant (28) sont compris par le support isolant (22).

2. Dispositif de détection (8) selon la revendication 1, dans lequel l'insert basse tension (32) est configuré en outre pour recevoir un signal d'alimentation et pour émettre une onde électromagnétique d'alimentation en fonction du signal d'alimentation,
l'insert haute tension (30) étant configuré pour recevoir l'onde électromagnétique d'alimentation émise et pour fournir un signal d'entrée représentatif du signal d'alimentation au transpondeur (24),
le transpondeur (24) étant configuré pour acheminer une partie du signal d'entrée à chaque capteur (26) afin d'alimenter chaque capteur (26).

3. Dispositif de détection (8) selon la revendication 1 ou 2, dans lequel l'insert haute tension (30) comprend une prise (40), le transpondeur (24) étant agencé dans la prise (40).

4. Dispositif de détection (8) selon l'une quelconque des revendications 1 à 3, dans lequel le transpondeur (24) est configuré pour moduler un signal primaire comprenant les informations de détection reçues de chaque capteur (26) à une fréquence de fonctionnement prédéterminée, la fréquence de fonctionnement étant incluse dans une bande de fréquences allant de 125 KHz à 5850 MHz, par exemple une bande de fréquences allant de 800 Hz à 1000 MHz.

5. Dispositif de détection (8) selon l'une quelconque des revendications 1 à 4, dans lequel au moins un capteur (26) est un capteur de température (26) ou un capteur de pression (26) agencé dans la prise (40).

6. Dispositif de détection (8) selon l'une quelconque des revendications 1 à 5, dans lequel l'insert basse tension (32) est configuré pour recevoir une onde électromagnétique de décharge générée par des décharges partielles, et pour fournir, en tant que sortie, un signal de décharge en fonction de l'onde électromagnétique de décharge.

7. Ligne de transmission (2) comprenant un dispositif de détection (8) selon l'une quelconque des revendications 1 à 6, la ligne de transmission (2) comprenant en outre un tuyau de mise à la terre (6) et un élément haute tension (4) agencé à l'intérieur du tuyau de mise à la terre (6) et espacé du tuyau de mise à la terre (6), le support isolant (22) étant agencé à l'intérieur du tuyau de mise à la terre (6) pour supporter mécaniquement l'élément haute tension (4), l'insert basse tension (32) étant en contact avec le tuyau de mise à la terre (6) par l'intermédiaire d'un élément isolant externe (36), et l'insert haute tension (30) étant en contact avec l'élément haute tension (4) par l'intermédiaire d'un élément isolant interne (34).

8. Ligne de transmission (2) selon la revendication 7, dans laquelle l'élément isolant interne (34) comprend une bobine d'induction (38) présentant une borne connectée à l'élément haute tension (4) et une autre borne connectée à l'insert haute tension (30).

9. Ligne de transmission (2) selon la revendication 7 ou 8, dans laquelle l'élément haute tension (4) comprend un sectionneur (42) présentant une électrode fixe (16) et un conducteur (14), le support isolant (22) supportant mécaniquement l'électrode (16), le conducteur (14) pouvant être actionné pour se déplacer entre une position engagée, dans laquelle une extrémité distale (20) du conducteur (14) est en contact électrique avec une région de contact de l'électrode (16), et un position désengagée, dans laquelle l'électrode (16) et le conducteur (14) ne sont pas en contact électrique l'un avec l'autre, un aimant (44) étant agencé à l'extrémité distale (20) du conducteur (14), un commutateur (46) étant agencé au niveau de la région de contact de l'électrode (16), le commutateur (46) étant connecté au transpondeur (24) pour former un capteur (26) du dispositif de détection (8), l'aimant (44) étant configuré pour amener le commutateur (46) dans un premier état quand le conducteur (14) est dans la position engagée, et pour amener le commutateur (46) dans un second état quand le conducteur (14) est dans la position désengagée.

10. Ligne de transmission (2) selon la revendication 9, dans laquelle le conducteur (14) peut être actionné en outre pour se déplacer dans une position rétractée, dans laquelle le conducteur (14) est séparé de l'électrode (16), l'extrémité distale (20) du conducteur (14) étant désengagée de la région de contact de l'électrode (16), le conducteur (14) et l'électrode (16) n'étant pas en contact électrique l'un avec l'autre, le conducteur (14) étant rétracté dans un manchon (48), l'extrémité distale (20) du conducteur (14) étant située à une entrée (50) du manchon (48), un commutateur de confirmation (46B) étant agencé à l'entrée (50) du manchon (48), l'aimant (44) étant configuré pour amener le commutateur de confirmation (46B) dans un premier état quand le conducteur (14) est dans la position rétractée, et pour amener le commutateur de confirmation (46B) dans un second état quand le conducteur (14) n'est pas dans la position désengagée.
